# EUROPEAN PATENT SPECIFICATION

(11) **EP 2 937 147 B1**
(45) Date of publication and mention of the grant of the patent: **16.11.2016**
(21) Application number: 14165415.2
(22) Date of filing: 22.04.2014
(51) Int. Cl.: B05D 7/14, B41M 3/00, B41M 5/00, C23F 1/00, B29L 7/00, B41J 2/205, G03F 7/20, B29C 45/37, B29C 33/42, B44C 1/22

(54) **METHOD WITH A STENCIL FOR STRUCTURING A SURFACE BY ETCHING**
VERFAHREN MIT EINER SCHABLONE ZUR STRUKTURIERUNG EINER OBERFLÄCHE DURCH ÄTZEN
PROCÉDÉ AVEC UN POCHOIR POUR LA STRUCTURATION D'UNE SURFACE PAR GRAVURE

(43) Date of publication of application: 28.10.2015
(73) Proprietor: AKK GmbH, 47809 Krefeld (DE)
(72) Inventor: Shaw, Karl Gregory, Midlothian, VA 23113 (US)
(74) Representative: Cohausz & Florack

(56) References cited:
- EP-A2- 1 251 398
- GB-A- 2 241 352
- GB-A- 2 350 321
- US-A- 5 776 639
- US-A1- 2007 166 652

## Description

The subject matter of the invention relates to a method for printing stencil and structuring a surface by etching, the method comprising: printing an etch resistant layer of the stencil by jetting etch resistant points, printing the etch resistant layer in areas of intentionally reduced etch depth with at least partially isolated dots.

Stencils for structuring a surface by etching are used for structuring the surface of metallic substrates. Such metallic substrates could comprise molds, e.g. injection molds, or embossing rollers.

Prior to the treatment of etching the stencil is applied on the surface of the metallic substrate. The stencil might be either directly printed on the metallic surface or printed on a stencil carrier and then transferred to the surface to be treated.

In general, etching a surface covered by a stencil is to be understood as constituting a binary treatment. Either the surface is covered by the stencil or not. Accordingly controlling the etch depth to obtain different etch depths despite of the same etch treatment requires additional measures. One is described in the European patent application with the file number 131194261.7. This application describes a two-step etching using a stencil with a stencil layer comprising two subareas which can be dissolved independently.

GB 2 350 321 A (D2) discloses a method of creating a masking pattern on the surface of a substrate by inkjet droplet deposition. A change in etch depth can be accomplished by printing a 3-D relief on the surface or by using a number of materials havin g different etch rates.

US 2007/0166652 A1 discloses a method for applying an etch-resistant stencil on a surface of a substrate and subsequently etching the substrate, generating a textured mold pattern on the surface.

EP 1 251 398 A2 refers to using an ink-jet printhead to deposit a mask on a surface for subsequent etching, making use of temperature control of the surface to solidity liquid droplets.

In GB 2 241 352 A (D4), the production of a photopolymer printing plate is described. A sheet, film or laminate of photosensitive polymeric material is covered with an opaque mask printed on its surface.

It is also known from the prior art to control the etch depth by making use of the fact that the etch resistant stencil layer will get undercutted during etching. The prior art describes stencil layers comprising at least partially isolated etch resistant dots in areas of potentially reduced etch depth. By this measure at least the averaged etch depth can be controlled by distributing the dots with a controlled density or distance in between the dots. In case the undercutting during the etching results in flaking off the dots from the surface not only the average depth but also the actual depth can be controlled.

In the prior art the etch resistant dots are identical with an etch resistant point printed as part of a matrix and accordingly cover a zone of the surface with a fixed size. Accordingly the control of the etch depth is determined by the resolution of the printing process.

To delimit the at least partially isolated etch resistant dots in areas of intentionally reduced etch depth from other areas of the stencil area such dots are understood to cover a zone, i.e. a surface area, reduced by at least 20 per cent due to undercutting in the course of the etching.

It is an object of the invention to improve the stencil for structuring a surface by etching known from the prior art in a way that the etch depth can be better controlled.

At least some of the etch resistant dots cover zones with controlled varying size. By varying the size of the etch resistant dots first the proportion of the undercutting effect and thereby the average etch depth is controlled. Second, the period within which the dots are flaking off is controlled. Thereby the actual etch depth as well as the average etch depth is controlled.

According to a further measure the dots are composed by at least two points. Composing one dot by at least two more or less overlapping points allows the printing of dots with various sizes.

Alternatively or cumulatively the points can have a controlled varying size thereby single points may constitute dots covering zones with controlled varying size.

Finally the average reduced etch depth is controlled again alternatively or cumulatively by dots having controlled varying distances. By controlling the distances the density of the dots is controlled and thus the average etch depth in the area of the intentionally reduced etch depth.

The invention relates to a method for printing a stencil, the method comprising: printing an etch resistant layer of the stencil by jetting etch resistant points; and printing the etch resistant layer in areas of intentionally reduced etch depth with at least partially isolated dots.

For the problems of the known methods for printing a stencil it can be referred to the statements above concerning the stencil for structuring a surface by etching.

According to the invention the method further comprises: printing at least some of the etch resistant dots covering zones with varying controlled size to control the actual etch depth and the average etch depth. For the advantages of the inventive solution it can be again referred to the statements with respect to the stencil above.

A first possibility to further improve the inventive method is by printing the dots by jetting at least two points. Jetting at least two points of etch resistant substances, e.g. ink or wax, easily enables the printing of etch resistant dots covering zones with varying controlled size.

Alternatively or cumulatively the method further comprises printing the dots by jetting points with controlled varying size. Modern print heads for jetting allow a size of the actual point to be jetted.

Finally the inventive method is further improved by alternatively or cumulatively comprising the step of printing the dots by jetting points with controlled varying distances.

There are a multitude of possibilities to implement and improve the present invention. Some of these possibilities are described in the following with reference to the following Figures. In these Figures
- Fig. 1: shows an embodiment of an stencil for structuring a surface by etching with areas of intentionally reduced etch depth,
- Fig. 2a)-c): shows a first embodiment of an isolated dot at the part of an etch resistant stencil layer in the course of an etch process,
- Fig. 3a)-c): shows a second embodiment of an isolated dot at the part of an etch resistant stencil layer in the course of an etch process and
- Fig. 4: a multitude of etch resistant dots as embodiments comprised in an etch resistant stencil layer in the method according to the invention.

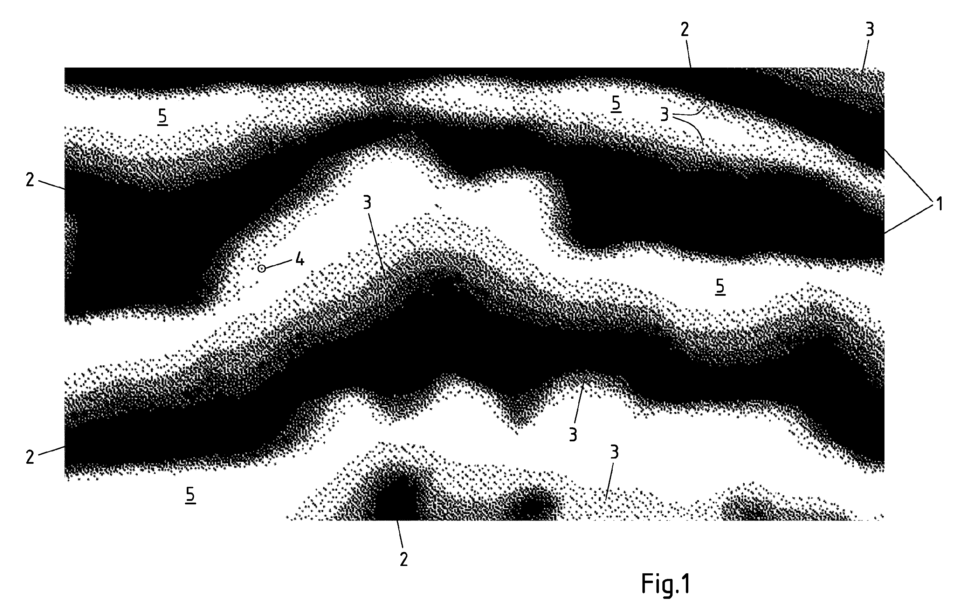

Fig. 1 of the drawings shows an embodiment of an stencil for structuring a surface by etching. The stencil comprises an etch resistant stencil layer 1 which in this Fig. comprises solid black areas 2. These solid black areas 2 are printed as a matrix of etch resistant points fully covering the corresponding area.

The stencil layer 1 also comprises dotted areas 3. These dotted areas 3 are covered at least partially isolated etch resistant dots 4. The dotted areas 3 are to be identified with areas of intentionally reduced etch depth.

Finally the stencil layer does not cover solid white areas 5. In these white areas the metallic surface is not protected against etching. Accordingly these are the areas with full etch depth.

In accordance with the invention at least some of the etch resistant dots 4 in the dotted areas 3 cover zones of the metallic surface with controlled varying size.

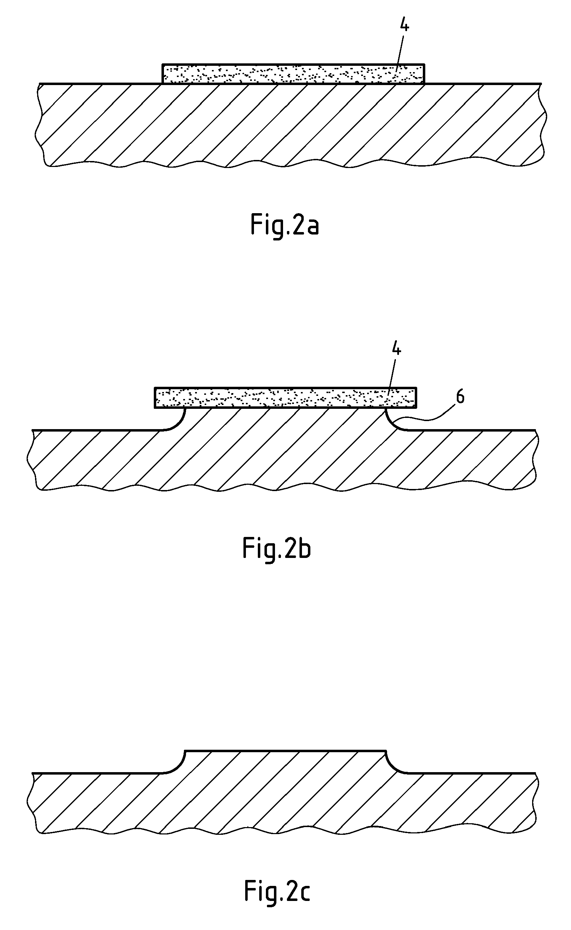

In Fig. 2 of the drawings it is shown how an etch resistant dot 4 with a lateral extension being high compared to the undercutting during etching covers the surface in the course of the etching process. In Fig. 2a) the situation prior to etching is shown. In Fig. 2b) the situation after etching is shown and due to the undercutting 6 the size of the etched zone is 20 per cent or more smaller than the zone covered by the dot 4 prior to etching. In Fig. 2c) the structure of the metallic surface after removing the stencil layer is shown.

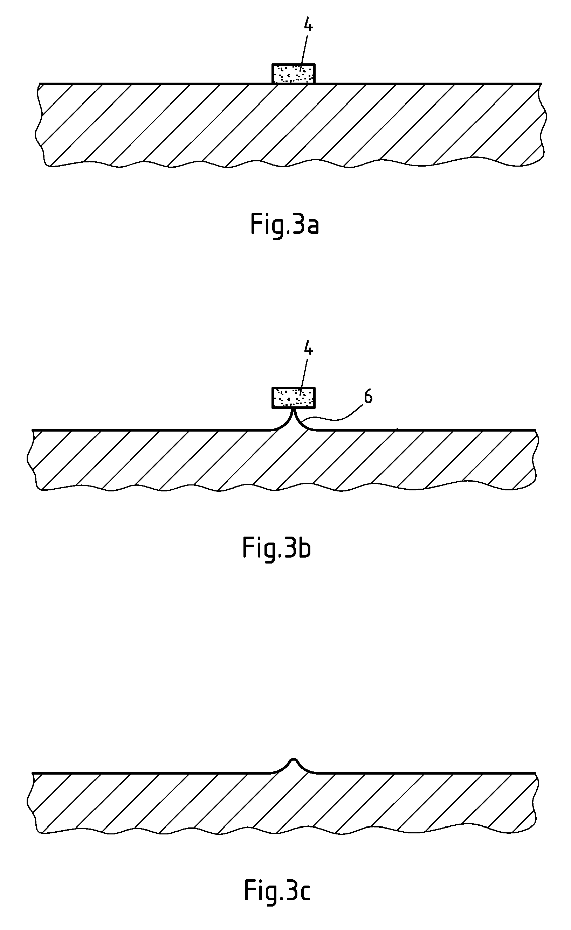

Fig. 3 shows a corresponding situation for a much smaller size of the dot 4. In this situation the dot 4 will flake off the surface prior to the finalization of the etching process and accordingly in Fig. 3c) also in the core area of the dot 4 the etching reaches a certain depth.

Having in mind the situation described with respect to Figs. 2 and 3 the controlled dot size does not only influence the averaged etch depth by the ratio of the surface covered by the dots 4 but also the factual etch depth in between a non-etched state and a fully-etched state. This by controlling the timing for flaking off the dots 4 from the surface.

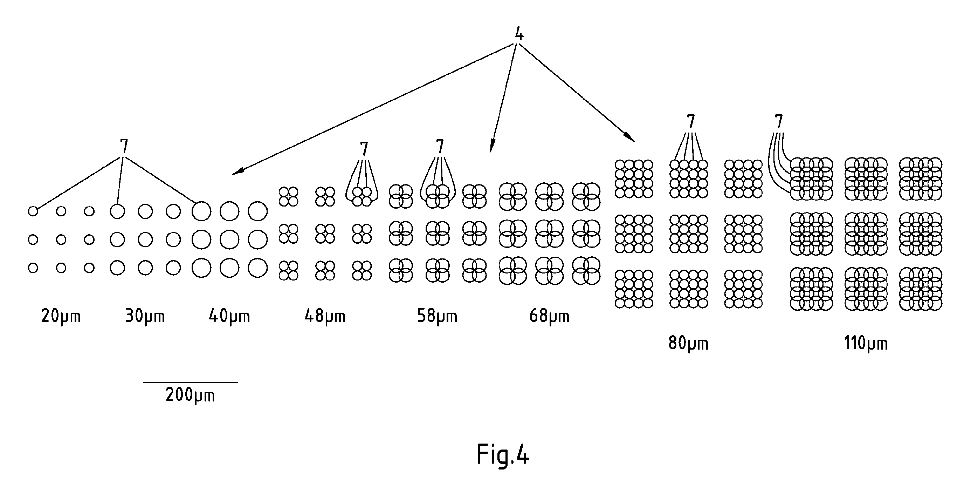

In Fig. 4 dots with dot sizes of 20 µm, 30 µm, 40 µm, 48 µm, 58 µm, 68 µm, 80 µm and 110 µm are represented. In this example the dot sizes of 20 µm, 30 µm and 40 µm are obtained by varying the size of the printing points 7. For the dot sizes 48 µm, 58 µm and 68 µm the size of the dots is controlled by composing the dots 4 from four printing points 7 and additionally controlling the size of the printing points 7. Also for the dot sizes of 80 µm and 110 µm the size of the dots 4 is controlled by composing them of 16 printing points 7 and again controlling additionally the size of the printing points 7. Not specifically shown in Fig. 4 is controlling the distances in between the dots 4. It is obvious that the average etching depth can be controlled also by controlling the density of the dots 4 by modifying the distance in between them.

The printing points 7 are jetted by ink-jet printing heads. Modern ink-jet printing heads can jet printing points of ink or wax with variable sizes, e.g. in between 20 µm and 40 µm, and of course can be controlled to compose dots 7 out of a plurality of printing points 7.

## Claims

1. Method for printing a stencil and structuring a surface by etching, the method comprising:
printing an etch resistant layer of the stencil by jetting etch resistant points,
printing the etch resistant layer in areas of intentionally reduced etch depth with at least partially isolated dots,
**characterized in that,**
the method further comprises:
printing at least some of the etch resistant dots covering zones with varying controlled size to control the actual etch depth and the average etch depth.

2. Method according to claim 2,
**characterized in that,**
the method further comprises printing the dots by jetting at least two points.

3. Method according to claims 1 or 2,
**characterized in that,**
the method further comprises printing the dots by jetting points with controlled varying size.

4. Method according to one of claims 1 to 3,
**characterized in that,**
the method further comprises printing the dots with controlled varying distances.

## Patentansprüche

1. Verfahren zum Drucken einer Schablone und Strukturieren einer Fläche durch Ätzen, wobei das Verfahren umfasst:
Drucken einer ätzresistenten Schicht der Schablone durch Jetten ätzresistenter Punkte,
Drucken der ätzresistenten Schicht in Bereichen von beabsichtigt reduzierter Ätztiefe mit mindestens teilweise isolierten Punkten,
**dadurch gekennzeichnet, dass**
das Verfahren weiter umfasst:
Drucken von mindestens einigen der ätzresistenten Punkte, die Zonen mit variierender gesteuerter Größe abdecken, um die tatsächliche Ätztiefe und die mittlere Ätztiefe zu steuern.

2. Verfahren nach Anspruch 2,
**dadurch gekennzeichnet, dass**
das Verfahren weiter das Drucken der Punkte durch Jetten von mindestens zwei Punkten umfasst.

3. Verfahren nach den Ansprüchen 1 oder 2,
**dadurch gekennzeichnet, dass**
das Verfahren weiter das Drucken der Punkte durch Jetten von Punkten mit gesteuerter variierender Größe umfasst.

4. Verfahren nach einem der Ansprüche 1 bis 3,
**dadurch gekennzeichnet, dass**
das Verfahren weiter das Drucken der Punkte mit gesteuerten variierenden Entfernungen umfasst.

## Revendications

1. Procédé d'impression d'un pochoir et de structuration d'une surface par gravure, ce procédé comprenant :
l'impression d'une couche résistant à la gravure du pochoir par jeter des points résistants à la gravure,
l'impression de la couche résistant à la gravure dans les zones de profondeur de gravure intentionnellement réduite avec des points au moins partiellement isolés,
**caractérisé en ce que**
ce procédé comprend en outre :
l'impression d'au moins certains des points résistant à la gravure en couvrant des zones ayant une taille variable contrôlée pour contrôler la profondeur réelle de la gravure et la profondeur moyenne de la gravure.

2. Procédé selon la revendication 2,
**caractérisé en ce que**
le procédé comprend en outre l'impression des points par jeter à au moins deux points.

3. Procédé selon la revendications 1 ou 2,
**caractérisé en ce que**
le procédé comprend en outre l'impression des points par jeter des points à taille variable contrôlée.

4. Procédé selon l'une quelconque des revendications 1 à 3,
**caractérisé en ce que**
le procédé comprend en outre l'impression des points avec des distances variables contrôlées.
